(19) Europäisches Patentamt
European Patent Office
Office européen des brevets

(11) **EP 4 343 355 A1**

(12) **EUROPEAN PATENT APPLICATION**

| | |
|---|---|
| (43) Date of publication: **27.03.2024   Bulletin 2024/13** | (51) International Patent Classification (IPC): **G01R 33/3815** (2006.01) |
| (21) Application number: **22275126.5** | (52) Cooperative Patent Classification (CPC): **G01R 33/3804;** G01R 33/3815 |
| (22) Date of filing: **23.09.2022** | |

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**KH MA MD TN** | (71) Applicant: **Siemens Healthcare Limited**<br>**Camberley, Surrey GU15 3YL (GB)**<br><br>(72) Inventor: **POPESCU, Stefan**<br>**91056 Erlangen (DE)**<br><br>(74) Representative: **Maier, Daniel Oliver**<br>**Siemens AG**<br>**Postfach 22 16 34**<br>**80506 München (DE)** |

(54) **A CRYOGEN-COOLED SUPERCONDUCTING MAGNET ASSEMBLY FOR A MAGNETIC RESONANCE IMAGING SCANNER**

(57)    The invention relates to a cryogen-cooled superconducting magnet assembly (1) for a magnetic resonance imaging scanner, comprising a cryogen container (8) containing a cryogen for providing a cryogenic temperature to a superconducting coil system, at least one cryoshield surrounding the cryogen container (8), an outer vacuum enclosure (6) surrounding the at least one cryoshield, a cryocooler assembly for removing heat from the superconducting magnet assembly (1), characterized in that the cryocooler assembly is configured for extracting heat from a part of the superconducting magnet assembly (1) which is maintained at an intermediate temperature, namely at a temperature between 80K and 285K, preferably between 100K and 273.13K, more preferred between 120K and 200K.

FIG 2

EP 4 343 355 A1

**Description**

The invention relates to a cryogen-cooled superconducting magnet assembly for a magnetic resonance imaging scanner, a method for cryocooling a superconducting magnet assembly, and a magnetic resonance imaging scanner.

A magnetic resonance imaging (MRI) scanner applies two kinds of magnetic fields across the imaging volume. A static, strong main magnetic field $B_0$ is used to align the magnetic spins inside the human body. Further, dynamic gradient magnetic fields are used to encode the spatial location of the magnetic resonance (MR) signals received from the magnetic spins. In most MRI scanners, the static magnetic field is produced by a main magnet composed of superconducting (SC) coils. Thereby, a high static magnetic field may be produced with low ohmic losses, but on the downside, it is necessary to cool the superconducting coils down to a temperature of around 4K, K standing for degrees Kelvin. Typically, a superconducting magnet is cooled using liquid helium, which is enclosed in a liquid helium vessel surrounding the superconducting coil. The helium vessel is typically enclosed by a thermal shield, which in turn is surrounded by an outer vacuum enclosure. A cryogen-cooled superconducting magnet typically also includes a cryocooler cold-head externally mounted to the outer vacuum enclosure, having its first stage in thermal contact with the thermal shield, and having its second stage in thermal contact with the superconducting main coil. The cryocooler cold-head removes boiled-off helium from the liquid helium vessel and condenses the helium gas back to liquid helium.

The gradient magnetic fields, on the other hand, are dynamic and are typically generated by gradient coils driven by high-power, high-intensity current pulses. The gradient coil system is typically disposed inside the bore of the main magnet, but may also be surrounding it. The gradient coil system operating at high power and high frequency may deposit thermal energy into the superconducting coils of the main magnet by three mechanisms: Firstly, by a thermal path, wherein the gradient coil system is heated up by the high currents. The thermal energy is radiated to the outer vacuum enclosure (OVC) of the superconducting magnet system and may penetrate the thermal shield down to the SC coils. Secondly, the gradient coils strongly vibrate when they are driven by high intensity current pulses due to the Lorentz forces within the strong static magnet field $B_0$. These vibrations result in mechanical energy which couples to the OVC and deeper into the conducting layers of the superconducting coils. The mechanical vibrations induce eddy currents into the electrically conducting OVC, which in turn induces eddy currents and vibrations into the next conducting layer and so on. Finally, the fast-changing stray fields from the gradient coils may penetrate through electrically conductive layers up to the superconducting coils. These fast-changing electromagnetic fields induce eddy currents into any conductive layer with associated ohmic losses and thereby increase the thermal load on the superconducting magnet system by an electromagnetic path.

In the prior art solution, the thermal shield is a high-conductivity structure between the gradient coils and the superconducting coils, which is being cooled at a temperature typically near 50K by the first stage of the cold-head period. This thermal shield completely surrounds the superconducting coils which are maintained at a temperature of around 4K.

Thus, the prior art relies on a cold-head with two cooling stages, which remove the heat at low temperatures of around 50K and 4K from the superconducting magnet. The associated cryocooler consumes about 7 kW of power and needs to be operated 24 h a day, every day, since the superconducting coils may not warm up, as this would result in quenching of the SC coils. MRI technology therefore has a very high energy consumption and associated negative impact on the environment. Furthermore, the total cooling reserve in prior art systems is insufficient for operation with a more energy-efficient, unshielded gradient coil. With an unshielded gradient coil, the power consumption of the gradient coil may be reduced, but at the expense of increasing the heat load on the superconducting magnet.

US 7,170,377 B2 discloses a cryogen-cooled recondensing superconducting magnet assembly, including superconducting magnet coils suitable for magnetic resonance imaging including a cryogen pressure vessel to contain a liquid cryogen reservoir, a vacuum vessel surrounding the pressure vessel, a first thermal shield surrounding and spaced from the pressure vessel, a second thermal shield surrounding and spaced from the first thermal shield, wherein the second thermal shield surrounding the first thermal shield reduces a radiation heat load from the first thermal shield to the pressure vessel lowering boil-off of cryogen gas under conditions of failure or power off of the cryocooler. Thus, a second thermal shield is introduced, which however is meant to prevent quenching of the superconducting coils only when the cryocooler fails. The cooling efficiency of the system when under normal operation appears not to be significantly improved.

It is an object of the invention to provide a cryogen-cooled superconducting magnet assembly having an improved cooling efficiency, and an associated cooling method, which enables cryocooling at lower energy consumption than the prior art systems.

This object is met or exceeded by a cryogen-cooled superconducting magnet assembly for a magnetic resonance imaging scanner according to claim 1, a method for cryocooling a superconducting magnet assembly according to claim 10, and a magnetic resonance imaging scanner according to claim 15.

According to a first aspect, the invention provides a cryogen-cooled superconducting magnet assembly for a magnetic resonance imaging scanner, comprising a cryogen container containing a cryogen for providing a cryogenic temperature to a superconducting coil system, at least one cryoshield surrounding the cryogen container, an outer vacuum enclosure surrounding the at least one cryoshield, and a cryocooler assembly for removing heat from the superconducting magnet assembly. According to the invention, the cryocooler assembly is configured for extracting heat from a part of the superconducting magnet assembly which is maintained at an intermediate temperature, namely at a temperature between 80K and 285K, preferably between 100K and 273.13K, more preferred between 120K and 200K. The heat may be removed from an intermediate temperature reservoir to a hot reservoir at room temperature, preferably to the surroundings of the MRI scanner, or to the OVC, which may also be actively cooled to a temperature below room temperature and above 0°C. As explained in more detail below, the invention has realized that it is more efficient to remove thermal energy from high temperatures than from low temperatures. Therefore, the inventive cooling solution, which is more efficient than the prior art, concentrates on capturing and removing the heat induced by the gradient coils into the SC magnet system as soon as possible and at as high as possible temperatures, preferably of intermediate cooling stages. By contrast, the cooling efficiency of the prior art is fundamentally limited by the fact that the first cooling stage of the cold-head operates at low temperatures of 50-60K, while at the same time having to remove a high quantity of thermal energy.

The inventive solution thereby serves the unmet needs of reducing the power consumption of MRI scanners and achieving a green environmental footprint for MRI technology. The inventive solution also reduces the time required for cooling down a superconducting magnet before putting it in operation. By contrast, the prior art requires a long cooldown time of the superconducting magnet after warm shipping to site or recovery after a quench.

The superconducting magnet assembly is suitable for a magnetic resonance imaging scanner, however it may also be used for other applications. The SC magnet assembly may in particular generate the main magnetic field for an MRI system, which may for example have a static magnetic field strength of 0.5-14 T, preferably 1-7 T, more preferred 1.5-3 T. The SC coils of the superconducting magnet assembly are cryogen cooled, wherein the cryogen may be helium, though other cryogens may also be used. In the following, when reference is made to helium, it is understood that other suitable cryogenic fluids may also be meant.

The superconducting coil system may have a closed magnet design or an open magnet design. Closed magnets typically have a single, tubular-shaped superconducting coil assembly having a bore, in which the imaging volume is disposed. Typically, the gradient coil system is inside the bore. A closed magnet coil assembly may include several radially aligned SC main coils, which are spaced from each other in the longitudinal (z) direction and each carry a large direct electric current in the same direction. The SC coils thereby create a static magnetic field of high uniformity within an imaging volume centered within the magnet's bore, where the subject to be imaged is placed. Open magnets, including C-shaped magnets, typically use two spaced-apart coil assemblies, wherein the space between the two coil assemblies comprises the imaging volume. These open magnet designs allow better access to the patient during imaging and reduce anxiety and feelings of claustrophobia on the side of the patient. The cryogen container, as well as the cryoshield and OVC is adapted to the respective magnet design.

The superconducting magnet assembly of the invention comprises a cryogen container containing a cryogen (e.g. helium) for providing a cryogenic temperature to a superconducting coil system. The cryogenic temperature may be a critical temperature which allows superconductivity in the magnet coils, in particular it may be below 30K, preferably below 20K, and more preferred between about 4K and 10K. The cryogen container which cools the SC coil system may be a cryogen pressure vessel, in which the SC coils are partially or totally immersed in the liquid cryogen, e.g. helium. This solution requires a relatively large quantity of liquid helium, and the boiled-off helium gas is extracted by the cold-head, the helium is recondensed and returned as liquid helium to the vessel, as described in US 7,170,377 B2. The cryogen container is adapted in shape to the shape of the SC coils, and may be made of steel. However, the cryogen container may also be a system of cooling pipes circulating the cryogen along closed loops. These cooling pipes are in good thermal contact with the SC coil system to keep them at the working temperature. This newer, helium-saving solution relies on indirect cooling of the SC coils within a so-called dry magnet. However, the invention is applicable to both systems, wherein the cryogen container may either be a cryogen vessel in which the SC coils are immersed in the cryogen or alternatively the system of cooling pipes in which the cryogen circulates to keep the SC coils at the cryogenic temperature.

The cryogen container is surrounded by at least one cryo-shield. The cryoshield may be a high conductivity hollow structure, which encloses the SC coil system. In case of a closed magnet design, it may be a cylindrical structure, in particular having hollow walls which enclose the cryogen container and the SC coil system. The cryoshield may completely surround the SC coil system and the cryogen container, which have to be cooled to a cryogenic temperature of e.g. 4K. It captures and reduces the thermal radiation that reaches the SC coil system to an acceptable level. The thermal shield may be made of an aluminum alloy having a low thermal emissivity and high thermal conductivity. The space between the cryogen container and the cryoshield may be evacuated in order to provide best possible thermal isolation between them. In addition, passive heat reflector foils, for example comprising a multilayer thermal insulator or reflector may further be disposed between the cryogen container and the cryoshield, in order to further shield the SC coils (also referred to as SC coil system) from thermal radiation arising from the gradient coils.

The at least one cryoshield is surrounded by an outer vacuum enclosure (OVC), which is also termed bore tube. The bore tube may enclose all magnet parts. The space between the cryoshield and the OVC may be evacuated in order to provide best possible thermal isolation between them. The OVC may be electrically conductive in order to at least partially shield the SC magnet from stray fields generated by the gradient coils during scanning. To further reduce the thermal load from heat diffusing into the inner space enclosed by the OVC, this inner space may be kept at a low air pressure (vacuum) by evacuation of air molecules. Further, a passive heat reflector which may comprise multilayer thermal insulator/reflector may be disposed between the cryoshield and the OVC, in order to shield the successive layer of the superconducting magnet system from thermal radiation arising from the bore tube. In some embodiments, the bore tube stays at room temperature or even higher, being heated up by the heat developed in the gradient coils during scanning. In a closed magnet design, the OVC may have the approximate shape of a cylinder mantle with hollow walls. In case of an open magnet design, the cryogen container, the cryoshield and the OVC may each have two parts disposed on two opposing sides of the imaging volume.

The superconducting magnet assembly further comprises a cryocooler assembly for removing heat from the superconducting magnet assembly. The cryocooler assembly may comprise one or more Gifford-McMahon coolers, as described for example in US 7,170,377 B2, though other cryocoolers are also comprised by the invention. Such a cryocooler may extend through the OVC and the cryoshield within a sleeve, such that the cold end of the cryocooler may be positioned within the sleeve without destroying the vacuum within the OVC, and so that heat generated by the cryocooler motor is outside the OVC. Such a cryocooler may have a two-stage or multiple-stage cold-head, connected by flexible cryogen gas pipes to an external compressor or refrigerator. The cold-head motor circulates the cryogen gas and drives the various cooling stages. In the prior art, a first cooling stage of such cryocooler typically is thermally connected to the cryoshield, which is thereby maintained at temperature of about 50K-60K, and the second cooling stage operating at a temperature of around 4K is connected to the cryogen container.

According to the invention, a part of the superconducting magnet assembly is maintained at an intermediate temperature, namely a temperature between 80K and 285K, preferably between 100K and 273.13K, more preferred between 120K and 200K. The part which is maintained at this intermediate temperature may be actively cooled by the cryocooler assembly, for example by the first stage of a two-stage or multiple-stage cold-head of a cryocooler. The invention has recognized that an efficient cooling solution removes the heat mostly at higher temperatures, since this may be done at a higher coefficient of performance.

The part which is maintained at the intermediate temperature may be one of the at least one cryoshields. However, it may also be another part, preferably an electrically conductive part, for example a sheet or foil. The part of the superconducting magnet assembly which is maintained at the intermediate temperature may preferably be a thermally conductive part, in particular a part made of metal, e.g. made of an aluminium alloy or steel. It may be a part which is placed between the OVC and the cryoshield or the outer cryoshield. It may also be a part disposed between two cryoshields. Preferably, it may be a part which also performs a function in heat shielding successive layers of the magnet system from thermal radiation or electromagnetic induction from the outside, in particular from the gradient coils.

The coefficient of performance (COP) of a refrigerator system such as a cryocooler stage is the ratio of useful cooling provided $Q_C$ (or the amount of heat removed from the cold reservoir and added to hot reservoir) to the required work (or consumed energy) W:

$$COP = \frac{Q_C}{W}$$

Refrigeration systems can have a COP greater than one when less energy is required to move the heat from a cold reservoir into a hot reservoir than for converting some other form of energy into the same quantity of heat. According to the first law of thermodynamics, the theoretical performance limit of a refrigerator operating at maximum theoretical efficiency is given by:

$$COP_{max} = \frac{T_C}{T_H - T_C}$$

where $T_H$ and $T_C$ are the thermodynamic temperatures of the hot and cold heat reservoirs, respectively.

Therewith the minimum theoretical work required to remove a prescribed amount of thermal energy $Q_C$ from the cold reservoir is given by the equation:

$$W_{min} = Q_C \frac{T_H - T_C}{T_C}$$

Thus, the minimum work required for removing an amount of heat $Q_C$ increases with the temperature gap between the cold and the hot reservoirs $T_H - T_C$. Additionally, for the same amount of heat to be removed and for the same temperature gap, the minimum work required gets higher as the temperature of the cold reservoir $T_C$ goes lower. Therewith the most important learning disclosed by this invention is that an efficient cooling solution removes the heat mostly at higher temperatures. In advantageous embodiments, the temperature gap between various cooling stages is reduced as much as possible.

In view of the above findings, it is preferable that the cryocooler, in particular the first stage of a cryocooler cold-head, extracts heat at a temperature in the claimed range. Such heat may be moved from the intermediate temperature to room temperature, or to a slightly lower temperature, for example in the range between 273.13K and 285K. It may also be moved to a second intermediate temperature. The intermediate temperature, in other words the temperature of the intermediate reservoir, may be chosen such that the theoretical performance limits (COP) of the respective cooling stage is greater than 0.2, preferably greater than 0.4, most preferred greater than 1. For example, a maximum COP of 1.034 can be reached when extracting energy from an intermediate temperature of 150K to a room temperature reservoir at 295K.

According to an embodiment, the cryocooler assembly is configured for extracting heat from a first part of the superconducting magnet assembly maintained at a first intermediate temperature and transferring it to a second part of the superconducting magnet assembly maintained at a second intermediate temperature between 200K and 285K. In this embodiment, the maximum COP is even further increased, since the temperature gap between various cooling stages is reduced as much as possible. In particular, the maximum COP for moving heat from this second intermediate temperature to the hot reservoir, i.e. to room temperature at for example 295K, is very high, resulting in a very high cooling efficiency for this last cooling step. On the other hand, the maximum COP of the cooling stage for moving heat from the first intermediate temperature to the second intermediate temperature is also above 1. In useful embodiments, the first intermediate temperature may be between 80K and 200K, preferably between 100K and 180K.

The second intermediate temperature is preferably between 200K and 285K, preferably between 250K and 283K. By introducing two stages at intermediate temperature, the cooling efficiency is further increased. The first and second parts may be a first and second cryoshield, but may also be other parts of the superconducting magnet assembly, as described above.

According to an embodiment, the superconducting magnet assembly comprises a first cryoshield surrounding the cryogen container, and a second cryoshield surrounding the first cryo-shield, wherein the cryocooler assembly is configured for extracting heat from the second cryoshield maintained at an intermediate temperature, in particular at an intermediate temperature in the range between 80K and 285K, preferably between 100K and 273.13K, more preferred between 120K and 200K. The first cryoshield may correspond to a cryoshield as known in the art, which may be maintained at a relatively low temperature of 30K to 100K, preferably 40-70K. The part maintained at intermediate temperature is herein embodied in the second cryoshield, which may for example have a temperature of 150K. Moving heat captured by this second cryoshield to a temperature above 273K may be performed at a high maximum COP of one or above, for example 1.220 for moving heat from 150K to 273K. The temperature of 273.15K is an important limit, because it is the freezing temperature. The outer most enclosure of the superconducting magnet assembly, which is usually the OVC, may be actively cooled, but preferably not below the freezing point, since otherwise it would soon be covered in ice from condensed water. The second cryoshield may be similar to the first cryoshield. The space between the first and second cryoshields may be evacuated in order to provide best possible thermal isolation between them.

According to an embodiment, the cryocooler assembly comprises at least two cold-heads, wherein a first cold-head includes a cooling stage which is configured for extracting heat from the cryogen container, and wherein a second cold-head is configured for extracting heat from an intermediate temperature. The two cold-heads may belong to two cryocoolers. The cold-heads may be two-stage cold-heads. For example, a first cold-head can be a two-stage Gifford-McMahon cryocooler or a Stirling cryocooler. This first cold-head may include a cooling stage configured for extracting heat from the cryogenic temperature, i.e. a temperature below 30K. The second cold-head may be part of a cryocooler having lower power consumption and lower cooling capacity, for example a pulse-tube cryocooler or a Stirling cryocooler. The cooling capacity of the cold-head may also be adapted by adjusting the operation frequency of the cold-head motor, as described in DE 10 2014 222 856 B4. In an embodiment with two cold-heads, preferably cascaded cold-heads, so that one cold-head extracts heat from the intermediate temperature, in particular not from the cryogenic temperature, each cold-head can operate at another frequency, thereby adjusting the cooling performance according to the given heat load. Reference DE 10 2014 222 856 B4 is herewith enclosed herein by reference.

According to an embodiment, a first cold-head includes a first cooling stage configured for extracting heat from a first cryoshield, and a second cooling stage configured for extracting heat from the cryogen container, and wherein the second cold-head does not extract heat from the cryogen container and includes a cooling stage for extracting heat from the second cryoshield. This advantageous design uses cascaded "cold-heads", wherein the first cold-head operates at lower temperatures, in particular a first cooling stage may extract heat from a temperature as low as 50K, while the second cooling stage extracts the heat from the cryogen container, which may either be a helium vessel or a network of cooling pipes in thermal contact with the SC coils and circulating liquid helium. The motor of this first cold-head may be thermally insulated from the second cryoshield. It may be cooled together with the OVC. This first cold-head may extract the heat from a cold reservoir at below 30K for example 4K, into a low temperature reservoir at 40-60K, for example 50K, and finally into the reservoir at the OVC temperature, which may however be a second intermediate temperature. Since most of the heat load from the gradient coil operation shall be extracted by the second cold-head, the cooling capacities or the maximum equivalent heat loads, and thereby the required cooling power, are significantly reduced by this design. The second cold-head is designed to extract most of the thermal energy induced by the gradient coil activity into the superconducting magnet assembly at much higher temperatures compared to the prior art, namely at an intermediate temperature as disclosed herein. In an embodiment, a first stage of the second cold-head moves the heat captured by a second cryo-shield operating at an intermediate temperature, in particular at a first intermediate temperature of 80K to 200K, to the bore tube or OVC, which is maintained at a second intermediate temperature by the second stage of the second cold-head. This second intermediate temperature may be between 200K and 285K, for example at 283K. Therewith, the thermal radiation from the gradient coil directly reaching the bore tube is removed long before it reaches much colder parts of the cooling system. The global cooling performance in this embodiment using two cascaded cold-heads is therefore improved by a factor of over 10. In theory, the minimum theoretical power consumption may reduce from about 270W to around 14W with the global coefficient of performance improving by a factor of 19 at a COP=3.7. Thus, there is a good reason to expect that the real-world power consumption for cooling the magnet system would also significantly reduce as compared to the prior art.

According to an embodiment, the cryocooler assembly includes a cold-head having at least three cooling stages, wherein at least one of the cooling stages extracts heat from an intermediate temperature within the ranges disclosed herein. This embodiment may also be used in combination with a first and second cryoshield, but the part maintained at intermediate temperature may also form another part of the superconducting magnet assembly. For example, the first cooling stage of the three-stage cold-head may remove heat from the second cryo-shield at an intermediate temperature into the hot reservoir at room temperature. The second cooling stage may remove the heat from the first cryoshield operated at a low temperature between 40K and 80K. The third cooling stage may keep the SC coils at their cryogenic temperature. This embodiment may improve the cooling efficiency by a factor greater than 10 compared to the prior art. A two-stage cold-head can be extended into a three-stage or a four-stage cold-head by adding in succession an absorption cooler as the third cooling stage and/or a dilution refrigerator as the fourth cooling stage. This is for example disclosed in US 2005 0274124 or US 2002 09330 or US 2006 0174635, all disclosing multi-stage cryocoolers.

In an embodiment, the cold-head includes a cooling stage extracting heat from a first cryoshield, a cooling stage extracting heat from a second cryoshield, and a final cooling stage extracting heat from the cryogen container. The first and second cryoshields may be held at first and second intermediate temperatures, respectively. The first intermediate temperature may be between 80K and 200K, preferably between 100K and 180K. The second intermediate temperature may be between 200K and 285K, preferably between 250K and 283K.

According to an embodiment, the cryocooler assembly includes at least one cold-head having two or more cooling stages, wherein the cooling powers of the several cooling stages within the cryocooler assembly are configured to be similar within $\pm500\%$, preferably $\pm300\%$, of each other. By introducing an intermediate temperature, it is possible to more evenly distribute the required cooling power, which improves the efficiency. In some embodiments, the theoretical cooling power varies between 2 and 10 W, preferably between 2 and 4 W, resulting an overall reduction of required cooling power.

In an embodiment, the temperature gap between the various cooling stages is also reduced to less than 180K, preferably to between 30K and 150K. By avoiding temperature gaps as high as 240K, as in the prior art between 50K and 295K, the cooling power is also better distributed between the various cooling stages, thereby improving the cooling efficiency.

In an embodiment, the outer vacuum enclosure and/or the cryo-shield or one of the cryoshields is made of an electrically conducting material having an electrical resistivity of at least $70.0\times10^{-8}$ $\Omega$m, preferably at least $1.0\times10^{-6}$ $\Omega$m, more preferred at least $1.0\times10^{-4}$ $\Omega$m. Thereby, it may be possible to capture a large part of the energy deposed by the gradient coils into the superconducting magnet assembly at earlier stages. In an embodiment, the OVC and/or the or one of the cryoshield(s), may be used as an electromagnetic shield that captures stray fields of the gradient coils and converts them into heat. According to this embodiment, this is accomplished by manufacturing the OVC and/or the cryoshield(s), in particular the or one of the cryoshield(s), preferably the outer cryoshield, from an electrically conductive material having high ohmic losses, thus having a relatively high electrical resistivity. One way to achieve this is to use the same materials as those used by the prior art, but operating the cryo-shield(s) at higher temperatures. Thereby, and especially in the outer cryoshield, the electrical resistivity automatically increases because of the higher operational temperatures. The high ohmic losses will extract a significant part of the electromagnetic energy at the outer most shields of the magnet assembly, such that only a small amount of the electromagnetic energy radiated by the gradient coils may propagate into deeper layers of the magnet assembly and only a very small amount may reach the SC coils.

Further means may be present to avoid or minimize the electromechanical interactions between the conducting layers that would otherwise propagate the energy radiated by the gradient coil into the inner low temperature stages of the superconducting magnet assembly. In particular, the OVC and/or the cryoshields may be mechanically reinforced to avoid or at least significantly reduce their mechanical vibrations.

The invention is also directed to a method for cryocooling a superconducting magnet assembly, wherein the method comprises a step of operating the cryocooler so that it extracts heat at an intermediate temperature, namely at a temperature between 80K and 285K, preferably between 100K and 273.13K, more preferred between 120K and 200K. All embodiments and advantages described with respect to the cryogen-cooled superconducting magnet assembly may be applied to the method for cryocooling, and vice versa. The method may be applied to a superconducting magnet assembly for an MRI scanner as described herein. In particular, the superconducting magnet assembly may have the various cryoshields and embodiments using two or more cascaded cold-heads, as described herein. To achieve most benefits of the inventive cooling method, the various temperatures and heat loads of the various parts of the superconducting magnet assembly, in particular of the cryogen container, the at least one cryoshield and the OVC, may be adjusted manually or by using a computer program, in particular using an iterative optimisation algorithm, so as to minimize the total cooling power. To optimize the global cooling performance, the operational parameters of the cold-heads as well as the appropriate type of cold-heads may be selected to achieve the required cooling capacity.

According to an embodiment, the superconducting magnet assembly comprises a first cryoshield surrounding the cryogen container, and a second cryoshield surrounding the first cryo-shield, wherein the method comprises a step of operating the cryocooler so that it extracts heat from the second cryo-shield at an intermediate temperature as disclosed herein. By this method, the maximum achievable coefficient of performance of the cooling system may be optimized. In an embodiment, the second cryoshield may be held at a second intermediate temperature for example at between 200K and 285K.

According to an embodiment, the cryocooler assembly comprises at least two cold-heads, wherein a first cold-head includes a cooling stage which extracts heat from the cryogen container, and wherein a second cold-head extracts heat at an intermediate temperature. It has been shown that the efficiency can be best improved if two cascaded cold-heads are used, wherein only one cold-head includes a cooling stage, usually the second cooling stage, which operates at the cryogenic temperature and extracts heat from below 40K. The second cold-head preferably extracts the heat at a higher, intermediate temperature above 80K. It may for example have two stages at two intermediate temperatures, wherein a first stage is at a higher intermediate temperature of 200-285K, and a second stage may extract heat a lower intermediate temperature of between 80K and 200K. Thereby, the temperature gap between the various cooling stages is effectively reduced, which increases the cooling efficiency. A solution using two cryoshields may be used in a method of the invention. For example, according to an embodiment, the method includes steps of extracting heat at a cryogenic temperature from the cryogen container, extracting heat at low temperature between the cryogenic temperature and the intermediate temperature and the intermediate temperature from a cryoshield, and extracting heat at the intermediate temperature. According to an embodiment, the heat extracted at the cryogenic temperature is moved to a low temperature reservoir between the cryogenic and the intermediate temperature, for example to between 40K and 80K. The heat extracted at the intermediate temperature may be moved either to another intermediate temperature reservoir, for example from a low intermediate temperature to a high intermediate temperature as described herein. It may also be moved directly to the hot reservoir at room temperature. Each of these embodiments provides an improvement in cooling efficiency.

The invention is also directed to a magnetic resonance imaging scanner comprising a cryogen-cooled superconducting magnet assembly as described herein. The scanner may be an open-magnet or a closed-magnet scanner. It may operate at static magnetic fields between 0.5 T and 14 T, preferably between 1 T and 7 T. Every feature, embodiment and advantage described in relation to the superconducting magnet assembly may be applied to the MRI scanner and vice versa.

The invention shall now be described by means of examples with reference to the attached drawings, in which

Fig. 1    shows a schematic cross section through a superconducting magnet system according to the prior art;

Fig. 2    shows a schematic cross section through a superconducting magnet assembly according to a first embodiment of the invention;

Fig. 3    shows a schematic cross section through a part of a superconducting magnet assembly according to a second embodiment;

Fig. 4    shows a schematic cross section through a part of a superconducting magnet assembly according to a third embodiment.

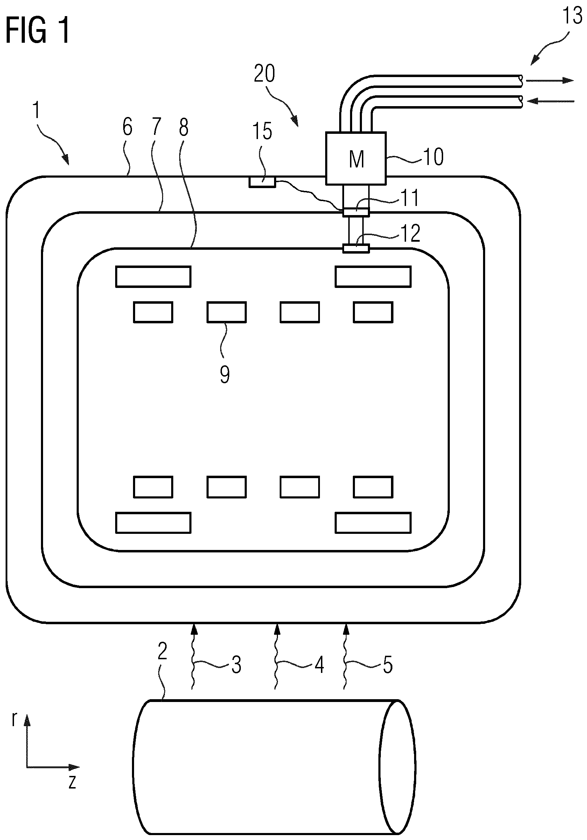

In the upper part of figure 1, a schematic cross section through a part of a superconducting magnet assembly 1 is depicted. The lower part schematically shows the gradient coil system 2, which in this case is arranged inside the bore of the superconducting magnet assembly 1. The magnet assembly 1 may have a roughly cylindrical shape surrounding the roughly cylindrical gradient coil system 2, which encloses the imaging volume. Thus, the cross section through the superconducting magnet assembly depicted at 1 shows only one side of the cylindrical magnet assembly, and is much exaggerated in size in the radial direction r in comparison to the longitudinal direction z. However, the figure may show the basic components of a superconducting magnet assembly 1, which are the superconducting coils 9, in this case surrounded by a liquid helium vessel 8, in which the SC coils 9 are partially or totally immersed in liquid helium. The helium vessel 8 is surrounded by a cryoshield 7, which in turn is surrounded by the OVC 6 of the magnet system 1. The three ways in which the gradient coil may depose energy into the magnet system 1 are illustrated by the three arrows pointing in that direction:

The thermal path 3 is the radiation of thermal energy from the gradient coil to the bore tube or OVC 6. The vibration of the gradient coils 2 may also couple to the bore tube 6 and deeper away into the conducting layers by way of electromechanical interactions. This mechanical path is indicated by arrow 4. Arrow 5 illustrates the electromagnetic path, wherein the fast-changing stray fields from the gradient coil 2 penetrates through the electrically conductive layers 6, 7, 8 up to the superconducting coils. They may induce eddy currents into any conductive layer with associated ohmic heating and thermal load on the magnet system 1.

The cooling system cooling system according to the prior art may include a cooling system or cryostat to keep it cold. The prior art cooling system comprises a two-stage cold-head 20 connected by flexible helium gas pipes 13 to an external compressor or refrigerator (not shown). The cold-head motor 10 circulates the cooling gas and drives the first cooling stage 11, which is typically operating at a temperature of near 50K. The first stage of the cold-head is usually thermally coupled to the cryoshield 7, which in this embodiment is a high-conductivity cylindrical structure between the gradient coil 2 and the superconducting coils. The cryoshield 7 may completely surround the SC coils. It captures and reduces the thermal radiation that reaches the SC coils to an acceptable level, thus preventing quenching. The second stage of the cold-head 12 is thermally connected to the helium vessel 8 and thereby holding the superconducting coils 9 at cryogenic temperature of around 4K.

Accordingly, the prior art uses a two-stage cold-head with the first cooling stage moving the heat from a temperature T2=50K cold reservoir to the room temperature at around T1=295K. The second cooling stage moves the heat from T3=4K cryogenic reservoir into the 50K reservoir. The cold-head specifications list a cooling capacity of 50 W at 50K and 2 W at 4K. Table 1 below shows the theoretical cooling performance limits of the prior art magnet system shown in Figure 1 by listing the associated maximum COP values in arbitrary units, the cooling capacity of typically used cold-heads in the unit Watt and the minimum theoretical power consumption to achieve these cooling requirements, also given in Watt.

**Table 1.** Global cooling performance of prior art

| Target temperatures | [K] | COP | [AU] | Cooling capacity [W] | | Cooling power | [W] |
|---|---|---|---|---|---|---|---|
| T1 | 295 | COP1 | 0.20 4 | Q1 | 50 | P1 | 245 |
| T2 | 50 | COP2 | 0.08 7 | Q2 | 2 | P2 | 23 |
| T3 | 4 | | | | | | |
| | | COP- qlob | 0.19 4 | Total | 52 | Total | 268 |

The total cooling capacity of prior art which is equivalent to the maximum heat load on the magnet system is 52W. The minimum theoretical power consumption is 268W. Therewith the global coefficient of performance of prior art is $COP_{glob}$ = 0.194.

The real-world cooling performance is significantly poorer than these theoretical figures. Nevertheless, it is obvious that with this arrangement the most power consumption is spent for the first cooling stage. It is a factor $\times 10$ larger than the power consumption required in the second cooling stage.

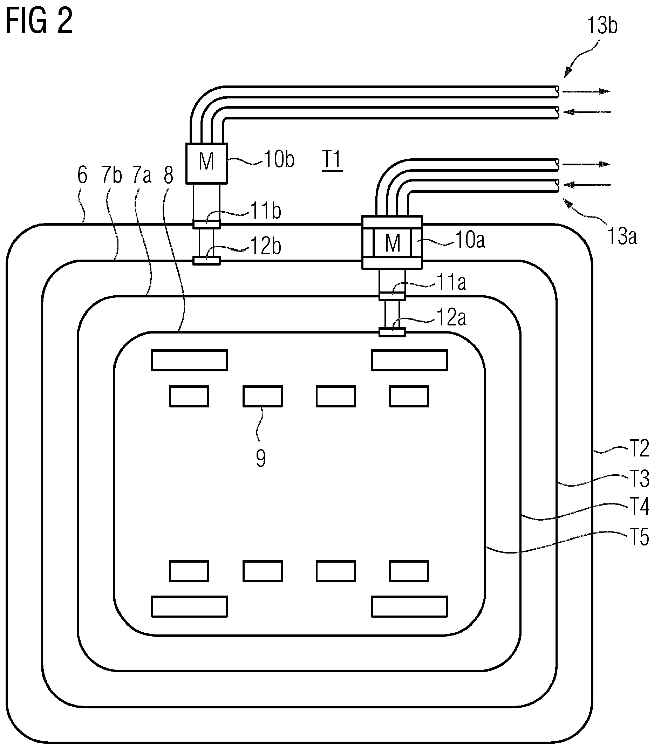

Figure 2 depicts an embodiment of the invention that uses two cascaded cold-heads. A first cold-head 10a is mounted similar to the prior art. The first cooling stage 11a extracts the heat from a first cryoshield 7a while the second cooling stage 12a extracts the heat from the cryogen container 8 cooling the SC coils 9, which is either a helium vessel or a network of cooling pipes in thermal contact with the SC coils 9 and circulating liquid He. The cold-head motor 10a is thermally insulated from the second cryoshield 7b and cooled together with the OVC 6. As further listed by Table 2, this cold-head extracts the heat from a cold reservoir at T5=4K into an intermediate reservoir at T4=50K and finally into a hot reservoir at a second intermediate temperature T2. As most of the heat load from the gradient coil operation shall be extracted by a second cold-head, the cooling capacities or the maximum equivalent heat loads Q3 and Q4 would be reduced by this design to a total load of 1.7W.

The second cold-head 10b is designed to extract most of the thermal energy induced by gradient coil activity into the magnet system at much higher temperatures compared to prior art. The first stage 11b cools the OVC to a temperature T2 of 283K, thus above the freezing point 0°C, but well below room temperature. The second stage 12b moves the heat captured by a second cryoshield 7b operating at temperature T3 to the bore tube or OVC 6, which is maintained at constant temperature T2 by the first stage 11b of the second cold-head. Therewith the thermal radiation from the gradient coil 2 directly reaching the bore tube 6 is removed long before it reaches much colder parts of the cooling system.

Table 2. Global cooling performance with two cascaded cold-heads

| Target temperatures | [K] | COP | [AU] | Heat-load | [W] | Cooling power | [W] |
|---|---|---|---|---|---|---|---|
| T1 | 295 | COP1 | 23.583 | Q1 | 47.3 | P1 | 2.01 |
| T2 | 283 | COP2 | 1.128 | Q2 | 3.0 | P2 | 2.66 |
| T3 | 150 | | | | | | |
| T2 | 283 | COP3 | 0.215 | Q3 | 1.5 | P3 | 6.99 |
| T4 | 50 | COP4 | 0.087 | Q4 | 0.2 | P4 | 2.30 |
| T5 | 4 | | | | | | |
| | | COP$_{glob}$ | 3.7 | Total | 52.00 | Total | 13.96 |

As revealed by Table 2, the maximum total heat load on the magnet system is the same as for prior art, namely 52W. However, the minimum theoretical power consumption reduces to around 14W with the global coefficient of performance (COP) improving by a factor ×19 to a COP$_{glob}$ = 3.7. There is good reason to expect that the real-world power consumption for cooling the magnet system would also significantly reduce as compared to prior art.

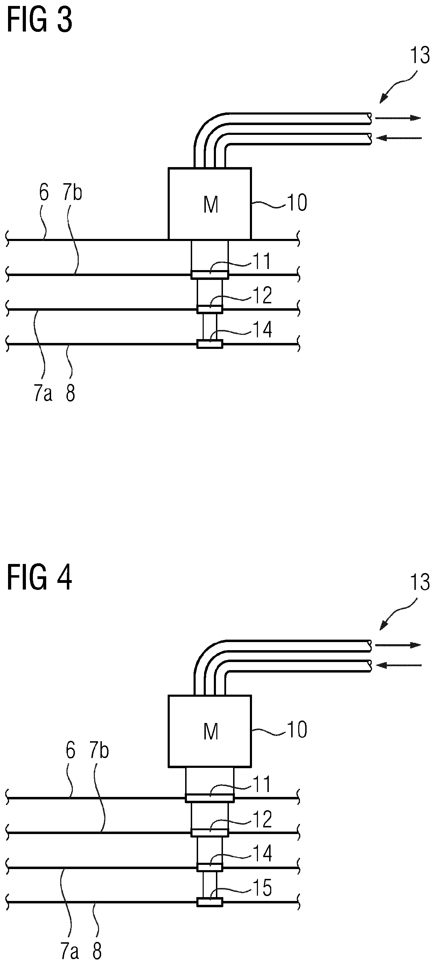

Fig.3 depicts a second embodiment of the inventive arrangement. The cooling system of this magnet assembly comprises a 3-stage cold-head 10 and two cryoshields 7a,7b. The OVC 6 is not actively cooled and is therefore part of the hot reservoir at room temperature T1. The first cooling stage 11 removes the heat from the cryoshield 7a at temperature T2 into the hot reservoir at room temperature T1. The second cooling stage 12 remove the heat from the cryo-shield 7b operated at temperature T3. The third cooling stage 14 keeps the SC coils at operating temperature T4.

The exemplary design parameters of the second embodiment listed by Table 3 shows that this embodiment also improves the cooling efficiency reaching an improvement in the global coefficient of performance by a factor better than ×16 when compared to prior art.

Table 3. Optimized global cooling performance with a 3-stage cold-head

| Target temperatures | [K] | COP | [AU] | Heat-load | [W] | Cooling power | [W] |
|---|---|---|---|---|---|---|---|
| T1 | 295 | COP1 | 12.409 | Q1 | 50.0 | P1 | 4.03 |
| T2 | 273 | COP2 | 0.224 | Q2 | 1.5 | P2 | 6.69 |
| T3 | 50 | COP3 | 0.087 | Q3 | 0.5 | P3 | 5.75 |
| T4 | 4 | | | | | | |
| | | COP$_{glob}$ | 3.158 | Total | 52.00 | Total | 16.47 |

Fig.4 depicts a third embodiment of the invention. The cooling system of this magnet assembly comprises a 4-stage cold-head 10 and two cryoshields 7a,7b. The difference to the second embodiment resides in the fact that the OVC 6 is actively cooled. The cryocooler cold-head comprises a first cooling stage 11 that removes the heat from the OVC 6 at temperature T2 into the hot reservoir at room temperature T1. The second cooling stage 12 remove the heat from the second cryo-shield 7b operated at temperature T3. The third cooling stage 14 keeps the first cryo-shield at operational temperature T4 and the fourth cooling stage maintains the SC coils at operating temperature T5.

The exemplary design parameters listed by Table 4 shows that this inventive arrangement further improves the cooling efficiency, thereby reaching an improvement in the global coefficient of performance by a factor $\times 21$ when compared to prior art.

Table 4. Global cooling performance with a 4-stage cold-head

| Target temperatures | [K] | COP | [AU] | Heat-load | [W] | Cooling power | [W] |
|---|---|---|---|---|---|---|---|
| T1 | 295 | COP1 | 12.409 | Q1 | 45.8 | P1 | 3.69 |
| T2 | 273 | COP2 | 1.220 | Q2 | 4.5 | P2 | 3.69 |
| T3 | 150 | COP3 | 0.500 | Q3 | 1.5 | P3 | 3.00 |
| T4 | 50 | COP4 | 0.087 | Q4 | 0.2 | P4 | 2.30 |
| T5 | 4 | | | | | | |
| | | $COP_{glob}$ | 4.100 | Total | 52.00 | Total | 12.68 |

Table 5 shows an alternative design using a 3-stage cold-head and two cryoshields, in which the target temperatures of various cooling stages are different from the ones in Table 3. With this solution, the global cooling performance is better than in the prior art (Table 1) by a factor of $\times 4$, yet still a factor of $\times 4$ worse than the optimized design arrangement in Table 3.

Table 5. Global cooling performance with a 3-stage cold-head, suboptimal design

| Target temperatures | [K] | COP | [AU] | Heat-load | [W] | Cooling power | [W] |
|---|---|---|---|---|---|---|---|
| T1 | 295 | COP1 | 1.034 | Q1 | 48.0 | P1 | 46.40 |
| T2 | 150 | COP2 | 0.500 | Q2 | 3.0 | P2 | 6.00 |
| T3 | 50 | COP3 | 0.087 | Q3 | 1.0 | P3 | 11.50 |
| T4 | 4 | | | | | | |
| | | $COP_{glob}$ | 0.813 | Total | 52.00 | Total | 63.90 |

This shows that, in order to optimize the global cooling performance for the same total heat load, it is advantageous if the power consumption over all cascaded cooling stages (P1, P2, P3, ...) is as equal as possible. This is the case for the exemplary designs in Table 3 & 4 and further demonstrated by the counterexamples in Tables 1 & 5. This design strategy indirectly results in the advantageous capturing and removing the most part of the heat load at higher temperatures within the very first stages of the cooling system.

**Claims**

1. A cryogen-cooled superconducting magnet assembly (1) for a magnetic resonance imaging scanner, comprising

   • a cryogen container (8) containing a cryogen for providing a cryogenic temperature to a superconducting coil system (9),
   • at least one cryoshield (7a, 7b) surrounding the cryogen container,
   • an outer vacuum enclosure (6) surrounding the at least one cryoshield,
   • a cryocooler assembly (10, 10a, 10b) for removing heat from the superconducting magnet assembly (1),

**characterized in that** the cryocooler assembly is configured for extracting heat from a part of the superconducting magnet assembly (1) which is maintained at an intermediate temperature, namely at a temperature between 80K and 285K, preferably between 100K and 273.13K, more preferred between 120K and 200K.

2. The superconducting magnet assembly (1) of claim 1,
   wherein the cryocooler assembly is configured for extracting heat from a first part (7, 7a) of the superconducting magnet assembly (1) maintained at a first intermediate temperature held between 80K and 200K, preferably between 100K and 180K, and transferring it to a second part (7b, 6) of the superconducting magnet assembly (1) maintained at a second intermediate temperature between 200K and 285K, preferably between 250K and 283K.

3. The superconducting magnet assembly (1) of claim 1 or 2,
   comprising a first cryoshield (7a) surrounding the cryogen container, and a second cryoshield (7b) surrounding the first cryoshield (7a), wherein the cryocooler assembly (10) is configured for extracting heat from the second cryoshield maintained (7b) at an intermediate temperature.

4. The superconducting magnet assembly (1) of one of the preceding claims, wherein the cryocooler assembly comprises at least two cold-heads (10a, 10b), wherein a first cold-head (10a) includes a cooling stage (12a) which is configured for extracting heat from the cryogen container, and wherein a second cold-head (10b) is configured for extracting heat from an intermediate temperature.

5. The superconducting magnet assembly (1) of claim 3 and 4, wherein the first cold-head (10a) includes a first cooling stage (11a) configured for extracting heat from a first cryoshield (7a), and a second cooling stage (12a) configured for extracting heat from the cryogen container (8), and wherein the second cold-head (10b)does not extract heat from the cryogen container (8) and includes a cooling stage (12b) for extracting heat from a second cryoshield (7b).

6. The superconducting magnet assembly (1) of one of the preceding claims, wherein the cryocooler assembly includes a cold-head having at least three cooling stages (11, 12, 14, 15), wherein one of the cooling stages extracts heat from an intermediate temperature.

7. The superconducting magnet assembly (1) of claim 6,
   wherein the cold-head includes a cooling stage (12) extracting heat from a first cryoshield (7a), a cooling stage (11) extracting heat from a second cryoshield (7b), and a final cooling stage (14) extracting heat from the cryogen container (8).

8. The superconducting magnet assembly (1) of one of the preceding claims, wherein the cryocooler assembly includes at least one cold-head having two or more cooling stages (11, 11a, 11b, 12, 12a, 12b, 14, 15), wherein the cooling powers of the several cooling stages within the cryocooler assembly are configured to be similar within $\pm 500\%$, preferably to within $\pm 300\%$, of each other.

9. The superconducting magnet assembly (1) of one of the preceding claims, wherein the outer vacuum enclosure (6) and/or the or one of the cryoshields (7, 7a, 7b) is made of an electrically conducting material having an electrical resistivity of at least $70.0 \times 10^{-8}$ $\Omega$m, preferably at least $1.0 \times 10^{-6}$ $\Omega$m, more preferred at least $1.0 \times 10^{-4}$ $\Omega$m.

10. A method for cryocooling a superconducting magnet assembly (1) for a magnetic resonance imaging scanner, wherein the superconducting magnet assembly (1) comprises

    • a cryogen container (8) containing a cryogen for providing a cryogenic temperature to a superconducting coil system (9),
    • at least one cryoshield (7a, 7b) surrounding the cryogen container (8),
    • an outer vacuum enclosure (6) surrounding the at least one cryoshield,
    • a cryocooler assembly (10) for removing heat from the superconducting magnet assembly (1),

    and wherein the method comprises a step of operating the cryocooler so that it extracts heat at an intermediate temperature, namely at a temperature between 80K and 285K, preferably between 100K and 273.13K, more preferred between 120K and 200K.

11. The method of claim 10, wherein the superconducting magnet assembly (1) comprises a first cryoshield (7a) surrounding the cryogen container (8), and a second cryo-shield (7b) surrounding the first cryoshield, and wherein the method comprises a step of operating the cryocooler so that it extracts heat from the second cryo-shield at an intermediate temperature.

12. The method of claim 10 or 11, wherein the cryocooler assembly comprises at least two cold-heads, wherein a first cold-head (12a) includes a cooling stage which extracts heat from the cryogen container (8), and wherein a second cold-head (12b) extracts heat at an intermediate temperature.

13. The method of one of claims 10 to 12, the method including steps of

    a. extracting heat at a cryogenic temperature from the cryogen container (8);
    b. extracting heat at low temperature between the cryogenic temperature and the intermediate temperature from a cryoshield (7, 7a, 7b);
    c. extracting heat at the intermediate temperature.

14. The method of claim 13, wherein the heat extracted at the cryogenic temperature is moved into the low temperature reservoir, and the heat extracted at the low temperature is moved into the intermediate temperature reservoir.

15. A magnetic resonance imaging scanner comprising a cryogen-cooled superconducting magnet assembly (1) according to any one of claims 1 to 9.

## FIG 1

FIG 2

# FIG 3

# FIG 4

Europäisches
Patentamt

European
Patent Office

Office européen
des brevets

# EUROPEAN SEARCH REPORT

Application Number

EP 22 27 5126

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 263 841 B1 (ARMAN BAYRAM [US] ET AL) 4 September 2007 (2007-09-04) <br><br> * column 2, lines 5-46 * <br> * figure 1 * <br> ----- | 1-3, 6-11, 13-15 | INV. G01R33/3815 |
| X | JP H01 291410 A (KOBE STEEL LTD) 24 November 1989 (1989-11-24) <br> * figure 1 * <br> ----- | 1-5,8-15 | |
| X | US 2010/271028 A1 (KAWAMOTO HIROMI [JP]) 28 October 2010 (2010-10-28) <br><br> * paragraph [0029] * <br> * paragraph [0060] * <br> * figures 1, 6 * <br> ----- | 1-3, 8-11, 13-15 | |
| X | US 2012/202697 A1 (CALVERT SIMON JAMES [GB]) 9 August 2012 (2012-08-09) <br><br> * paragraph [0065] – paragraph [0069] * <br> * figures 1, 6 * <br> ----- | 1-3, 8-11, 13-15 | |
| X | US 2020/096581 A1 (POURRAHIMI SHAHIN [US]) 26 March 2020 (2020-03-26) <br><br> * paragraph [0011] * <br> * paragraph [0025] – paragraph [0039] * <br> * figure 3 * <br> ----- | 1-3, 8-11, 13-15 | **TECHNICAL FIELDS SEARCHED (IPC)** <br><br> G01R |

The present search report has been drawn up for all claims

| Place of search | Date of completion of the search | Examiner |
|---|---|---|
| Munich | 3 March 2023 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 27 5126

This annex lists the patent family members relating to the patent documents cited in  the above-mentioned European search report.
The members are as contained in the European Patent Office EDP file on
The European Patent Office is in no way liable for these particulars which are merely given for the purpose of information.

03-03-2023

| Patent document cited in search report | | Publication date | Patent family member(s) | | Publication date |
|---|---|---|---|---|---|
| US 7263841 | B1 | 04-09-2007 | NONE | | |
| JP H01291410 | A | 24-11-1989 | NONE | | |
| US 2010271028 | A1 | 28-10-2010 | JP 2010269136 | A | 02-12-2010 |
|  |  |  | US 2010271028 | A1 | 28-10-2010 |
| US 2012202697 | A1 | 09-08-2012 | CN 102636765 | A | 15-08-2012 |
|  |  |  | GB 2488102 | A | 22-08-2012 |
|  |  |  | JP 2012161612 | A | 30-08-2012 |
|  |  |  | US 2012202697 | A1 | 09-08-2012 |
| US 2020096581 | A1 | 26-03-2020 | AU 2019347727 | A1 | 06-05-2021 |
|  |  |  | CA 3113951 | A1 | 02-04-2020 |
|  |  |  | CN 112840415 | A | 25-05-2021 |
|  |  |  | EP 3857572 | A1 | 04-08-2021 |
|  |  |  | US 2020096581 | A1 | 26-03-2020 |
|  |  |  | WO 2020068708 | A1 | 02-04-2020 |

EPO FORM P0459

For more details about this annex : see Official Journal of the European Patent Office, No. 12/82

**REFERENCES CITED IN THE DESCRIPTION**

**Patent documents cited in the description**

- US 7170377 B2
- DE 102014222856 B4
- US 20050274124 A
- US 200209330 B
- US 20060174635 A